# EUROPÄISCHE PATENTSCHRIFT

(11) **EP 1 160 360 B1**
(45) Veröffentlichungstag und Bekanntmachung des Hinweises auf die Patenterteilung: **11.09.2002**
(21) Anmeldenummer: 01111147.3
(22) Anmeldetag: 10.05.2001
(51) Int. Cl.: C30B 25/02, H01L 21/205

(54) **Verfahren zur Herstellung einer epitaxierten Halbleiterscheibe**
Process for producting an epitaxial layer on a semiconductor wafer
Procédé de production d'une couche épitaxiale sur une plaquette de semi-conducteur

(30) Priorität: 25.05.2000 DE 10025871
(43) Veröffentlichungstag der Anmeldung: 05.12.2001
(73) Patentinhaber: Wacker Siltronic Gesellschaft für Halbleitermaterialien Aktiengesellschaft, 84489 Burghausen (DE)
(72) Erfinder: Schmolke, Rüdiger, Dr., 84489 Burghausen (DE); Schauer, Reinhard, 83410 Laufen (DE); Obermeier, Günther, Dr., 83349 Palling (DE); Gräf, Dieter, Dr., 84489 Burghausen (DE); Storck, Peter, Dr., 84561 Mehring (DE); Messmann, Klaus, 84489 Burghausen (DE); Siebert, Wolfgang, Dr., 84561 Mehring (DE)
(74) Vertreter: Rimböck, Karl-Heinz, Dr.

(56) Entgegenhaltungen:
- EP-A- 0 711 854
- EP-A- 0 959 154
- WO-A-01/06044
- US-A- 4 859 626

## Beschreibung

Die Erfindung betrifft ein Verfahren zur Herstellung einer Halbleiterscheibe mit einer Vorderseite und einer Rückseite und einer auf der Vorderseite abgeschiedenen epitaktischen Schicht aus halbleitendem Material.

Nach dem Stand der Technik werden epitaxierte Halbleiterscheiben aus geeigneten Vorprodukten durch die Prozeßfolge Abtragspolieren - Endpolieren - Reinigen - Epitaxie hergestellt, wobei die Oberflächenrauhigkeit nach dem Abtragspolieren, gemessen mit dem Atomic-Force-Microscope-Verfahren (AFM) in einem Bereich von 1 µm mal 1 µm, je nach Prozeßführung etwa 0,5 bis 3 nm RMS (root-mean-square) und nach dem Endpolieren etwa 0,05 bis 0,2 nm RMS beträgt.

In der Patentanmeldung EP 711 854 A1 ist ein Verfahren zur Herstellung einer epitaxierten Scheibe beschrieben, in dem eine gesägt - geläppt - geätzte Siliciumscheibe abtragspoliert wird, wobei sich eine Oberflächenrauhigkeit von 0,3 bis 1,2 nm RMS (AFM, 1 µm mal 1 µm) einstellt, und zur Kostensenkung ohne Durchführung eines glättenden Endpolierschrittes eine epitaktische Siliciumschicht abgeschieden wird. Zwar ist die so hergestellte Epitaxieschicht einer unter vorheriger Anwendung eines Endpolierschrittes konventionell hergestellten Epitaxieschicht in ihren elektrischen Eigenschaften vergleichbar, jedoch führt der durch die relativ hohe Ausgangsrauhigkeit verursachte Anstieg an Lichtstreuzentren (localized light scatterers, LLS) auf der epitaxierten Oberfläche potentiell zum vermehrten Ausfall von auf diesen Scheiben hergestellten Bauelementen.

Es ist auch bekannt, daß Defekte in der Substratscheibe, die sich als Oxidpräzipitate nachweisen lassen, nach dem Abscheiden der epitaktischen Schicht Ursache für eine erhöhte Anzahl von Lichtstreuzentren sind. In der EP-959154 A1 wird eine der epitaktischen Abscheidung vorangestellte Wärmebehandlung der Substratscheibe vorgeschlagen, die die Zahl oberflächennaher Defekte reduziert. Es hat sich jedoch herausgestellt, daß die damit zu erzielende Reduktion insbesondere beim Einsatz von Substratscheiben, bei denen sich eine große Anzahl derartiger Defekte nachweisen läßt, unzureichend oder mit hohen Kosten verbunden ist. Die Effizienz der Defektreduktion hängt von der Dauer der Wärmebehandlung ab. Wenn die Wärmebehandlung nur in einem Maß durchgeführt wird, bei dem die dafür anfallenden Kosten in einem vertretbaren Rahmen bleiben, wird eine unerwünscht hohe Zahl von Lichtstreuzentren (localized light scatterers, LLS) auf der epitaxierten Oberfläche gefunden.

Es war daher die Aufgabe gestellt, ein Verfahren zu beschreiben, das zu einer epitaxierten Halbleiterscheibe führt, die die erwähnten Nachteile hinsichtlich der Rauhigkeit und der Anzahl an Lichtstreuzentren auf der epitaxierten Oberfläche nicht aufweist und auch für den Einsatz von Substratscheiben geeignet ist, die Defekte aufweisen, die als Oxidpräzipitate nachweisbar sind. Femer sollten die weiteren Eigenschaften der epitaxierten Halbleiterscheibe mindestens genau so gut sein wie die von nach dem Stand der Technik hergestellten epitaxierten Halbleiterscheiben.

Gegenstand der Erfindung ist ein Verfahren zur Herstellung einer Halbleiterscheibe mit einer Vorderseite und einer Rückseite und einer auf der Vorderseite abgeschiedenen epitaktischen Schicht aus halbleitendem Material, das durch folgende Prozeßschritte gekennzeichnet ist:
(a) Bereitstellen einer Substratscheibe aus Silicium mit einer polierten Vorderseite und einer bestimmten Dicke;
(b) Vorbehandeln der Vorderseite der Substratscheibe in Gegenwart von gasförmigem HCl und einer Silanquelle bei einer Temperatur von 950 bis 1250 Grad Celsius in einem Epitaxiereaktor, wobei die Dicke der Substratscheibe im wesentlichen unverändert bleibt; und
(c) Abscheiden der epitaktischen Schicht auf der Vorderseite der vorbehandelten Substratscheibe.

Das Verfahren macht eine Halbleiterscheibe zugänglich, bei der die Oberfläche der epitaktischen Schicht eine maximale Dichte von 0,14 Streulichtzentren pro cm² mit einem Streuquerschnitt von größer oder gleich 0,12 µm aufweist. Die Vorderseite der Substratscheibe besitzt vor dem Abscheiden der epitaktischen Schicht eine Oberflächenrauhigkeit von 0,05 bis 0,2 nm RMS, gemessen durch AFM auf einer 1 µm mal 1 µm großen Referenzfläche. Die Halbleiterscheibe eignet sich für die Verwendung in der Halbleiterindustrie, insbesondere zur Fabrikation von elektronischen Bauelementen mit Linienbreiten gleich oder kleiner 0,18 µm.

### Zu Schritt (a) der erfindungsgemäßen Prozeßfolge:

Zur Herstellung der erfindungsgemäßen epitaxierten Halblelterscheibe wird eine Sub-Substratscheibe, aus Silicium, die nach dem Abtrennen von einem Kristall beispielsweise geläppt und geätzt oder geschliffen und geätzt oder nur geschliffen wurde, oder nur im gesägten Zustand ist, einer Abtragspolitur und gegebenenfalls einer Endpolitur (finishing) unterzogen, wobei die Politur entweder auf beiden Seiten gleichzeitig oder nur auf der Vorderseite der Substratscheibe durchgeführt wird. Ein geeigneter Polierprozeß für zweiseitig polierte Substratscheiben ist beispielsweise in der DE-199 05 737 C1 beschrieben. Die Substratscheibe kann defektarm oder defektbehaftet sein in Bezug auf Defekte, die sich als große oberflächennahe Oxidpräzipitate oder als mit Oxid angefüllte Leerstellenagglomerate (voids) nachweisen lassen.

Gemäß einer bevorzugten Ausführungsform der Erfindung, die besonders unter dem Gesichtspunkt geringer Kosten bevorzugt ist, wird in Schritt (a) des Verfahrens eine Substratscheibe aus Silicium mit einer polierten Vorderseite bereitgestellt, bei deren Herstellung nur ein einziger Polierschritt, nämlich eine Abtragspolitur, zum Einsatz kommt. Auf eine Endpolitur wird verzichtet. Die Substratscheibe wird von der Poliermaschine entfernt und einer Reinigung und Trocknung nach dem Stand der Technik unterzogen. Die Reinigung kann entweder als Batchverfahren unter gleichzeitiger Reinigung einer Vielzahl von Substratscheiben in Bädern oder mit Sprühverfahren oder auch als Einzelscheibenprozeß ausgeführt werden.

Gemäß einer weiteren, bevorzugten Ausführungsform der Erfindung wird eine polierte Substratscheibe aus Silicium in Schritt (a) bereitgestellt, die reich an Defekten ist, die sich als große oberflächennahe Oxidpräzipitate oder als mit Oxid angefüllte Leerstellenagglomerate nachweisen lassen. Eine solche Substratscheibe liegt im Sinne der Erfindung vor, wenn die Dichte der Defektkeime in mindestens einem Gebiet der Sub-Substratscheibe nach einer OSF-Testung (Bedingungen: Naßoxidation bei 1100°C für 2 Stunden mit anschließender Secco-Behandlung für 3 Minuten (Dotierung: p-) oder Naßoxidation bei 1100°C für 2 Stunden mit anschließender Wright-Behandlung für 3 Minuten (Dotierung: p+)) einen Wert von mindestens 5/cm² (oberflächennahe Oxidpräzipitate) erreicht oder nach 20 min nicht-geschüttelter Secco-Behandlung im leerstellenreichen Gebiet der Scheibe mindestens 2 µm große Secco etch pits und/oder large pits mit einer Dichte von mindestens 0,05/cm² (mit Oxid angefüllte Leerstellenagglomerate) gefunden werden. Dies ist in der Regel der Fall, wenn die Sauerstoff-Konzentration im Bereich von 3*10¹⁷ - 9*10¹⁷ cm⁻³, vorzugsweise 5*10¹⁷ - 7,5*10¹⁷ cm⁻³, liegt und die Konzentrationsbestimmung nach der amerikanischen ASTM-Norm erfolgt, und in Bezug auf Dotierstoffe und deren Konzentrationen in der Substratscheibe mindestens eine der folgenden Bedingungen erfüllt ist:
Die Stickstoff-Konzentration liegt im Bereich von 1*10¹⁰ - 5*10¹⁵ cm⁻³, vorzugsweise 5*10¹² - 5*10¹⁵ cm⁻³; die Kohlenstoff-Konzentration liegt im Bereich von 1*10¹⁵ - 5*10¹⁷ cm⁻³, vorzugsweise 1*10¹⁶ - 5*10¹⁷ cm⁻³, und die Bor-Konzentration liegt im Bereich von mehr als 5*10¹⁷ cm⁻³. Unter die beschriebene Kategorie defektbehafteter Substratscheiben fallen insbesondere Siliciumscheiben, auf denen eine ringförmige Anhäufung von Defektkeimen, ein sogenannter OSF-Ring, nachweisbar ist (OSF = oxidation induced stacking fault) und Siliciumscheiben, die eine hohe Dichte von mit Oxid angefüllten Leerstellenagglomeraten (voids) im Kristall aufweisen (M.Hourai et al. in The Electrochem. Soc. PV98-1 (1998), Seite 453 und G.Kissinger et al. in Appl.Phys.Lett. (1998), Seite 223).

Die defektbehaftete Substratscheibe kann ebenfalls in einem nur abtragspolierten Zustand bereitgestellt werden, aber auch neben einer Abtragspolitur noch einer Endpolitur unterzogen worden sein.

### Zu Schritt (b) der erfindungsgemäßen Prozeßfolge:

Die polierte Oberfläche der Vorderseite der Substratscheibe wird während Schritt (b) des Verfahrens so konditioniert, daß die Qualität der nachfolgend aufwachsenden epitaktischen Schicht hinsichtlich der maximalen Anzahl von Lichtstreuzentren auf der Oberfläche der Schicht die eingangs gestellte Aufgabe löst. Dies gelingt überraschenderweise dadurch, daß die Substratscheibe in Schritt (b) des Verfahrens, vorzugsweise eine Siliciumscheibe, in Gegenwart von gasförmigem HCl und einer Silanquelle bei einer Temperatur von 950 bis 1250 Grad Celsius, bevorzugt 1050 bis 1150 Grad Celsius, in einem Epitaxiereaktor behandelt wird. Die Konzentration des gasförmigen HCl und der Silanquelle wird so eingestellt, daß es im wesentlichen weder zu einer Siliciumabscheidung noch zu einem Ätzabtrag von Halbleitermaterial kommt und sich die Dicke der Substratscheibe nicht wesentlich verändert. Eine gewisse Abweichung vom Gleichgewichtszustand kann toleriert werden, wobei der tolerierbare Bereich zwischen höchstens 0,5 µm/min Abscheidung und höchstens 0,2 µm/min Ätzabtrag liegt und im Hinblick auf die Dicke der Substratscheibe eine Abnahme der Dicke von bis zu 0,5 µm, vorzugsweise bis zu 0,2 µm, oder eine Zunahme der Dicke von bis zu 0,5 µm, vorzugsweise bis zu 0,2 µm, miteinschließt.

Abätzen und Abscheiden laufen mit hinreichend hoher Reaktionsrate ab, so daß das Silicium auf der Oberfläche quasi mobil ist und es zu einer Glättung der Oberfläche und zum Entfernen von Defekten auf der Oberfläche kommt. Neben gasförmigem HCl und der Silanquelle kann die Atmosphäre zusätzlich ein Dotiergas enthalten. Dies ist insbesondere dann bevorzugt, wenn die Vorbehandlung unter Bedingungen durchgeführt wird, bei denen Material im tolerierbaren Umfang abgeschieden wird. Am Ende der Vorbehandlung steht eine defektfreie, geglättete, einkristalline Siliciumoberfläche. In der Literatur ist beschrieben, daß HCl in einer Wasserstoffatmosphäre eine ätzende und glättende Wirkung auf eine Oberfläche aus Silicium ausübt (H.M. Liaw und J.W.Rose in: Epitaxial Silicon Technology, Academic Press Inc., Orlando Florida 1986, Seiten 71-73 und M.L. Hammond in Handbook of Thin-Film Deposition Processes and Techniques, Noyes Publications 1988, Seite 32 und 33). Es wurde jetzt überraschend gefunden, daß durch die zusätzliche Anwesenheit einer Silanquelle die Glättung der Oberfläche und das Entfernen von Kristalldefekten deutlich verbessert und beschleunigt werden kann.

Besonders bevorzugt ist es, in einem ersten Teilschritt natürliches Oxid (native oxide) von der Vorderseite der Substratscheibe zu entfernen, vorzugsweise indem die Substratscheibe einer reinen Wasserstoffatmosphäre bei einer Temperatur von 900 bis 1200 Grad Celsius, bevorzugt bei einer Temperatur von 1100 bis 1150 Grad Celsius, in einem Reaktor ausgesetzt wird, der auch zur nachfolgenden epitaktischen Abscheidung einer Siliciumschicht benützt wird. Das native Oxid kann aber auch auf eine andere, bekannte Weise entfernt werden, beispielsweise durch Behandeln der Substratscheibe mit Fluorwasserstoff. Die Vorbehandlung gemäß Schritt (b) erfolgt dann in einem zweiten Teilschritt, vorzugsweise indem eine Mischung umfassend eine Silanquelle, gasförmiges HCl und Wasserstoff in den Epitaxiereaktor eingeleitet wird. Falls natives Oxid zuvor mit Wasserstoff entfernt wurde, reicht es aus, der schon vorhandenen Wasserstoffatmosphäre die Silanquelle und HCl zuzuführen.

Als Silanquelle kommen insbesondere Silan (SiH₄), Dichlorsilan (SiH₂Cl₂), Trichlorsilan (SiHCl₃), Tetrachlorsilan (SiCl₄) oder eine Mischung der genannten Stoffe in Frage. Besonders bevorzugt ist Trichlorsilan.

### Zu Schritt (c) der erfindungsgemäßen Prozeßfolge:

Im letzten Schritt der Prozeßfolge wird die durch die Behandlung gemäß Schritt (b) erhaltene Substratscheibe nach einem Standardverfahren mit einer epitaktischen Schicht auf mindestens der Vorderseite versehen. Dies geschieht nach einem CVD-Verfahren (chemical vapor deposition), bei dem vorzugsweise Silan (SiH₄), Dichlorsilan (SiH₂Cl₂), Trichlorsilan (SiHCl₃), Tetrachlorsilan (SiCl₄) oder eine Mischung der genannten Stoffe zur Scheibenoberfläche geführt werden, sich dort bei Temperaturen von 600 °C bis 1250 °C zu elementarem Silicium und flüchtigen Nebenprodukten zersetzen und eine epitaktische, das heißt einkristalline, kristallographisch an der Halbleiterscheibe orientiert aufgewachsene Siliciumschicht bilden. Bevorzugt werden Siliciumschichten mit einer Dicke von 0,3µm bis 10µm. Die Epitaxieschicht kann undotiert oder beispielsweise mit Bor, Phosphor, Arsen oder Antimon gezielt dotiert sein, um den Leitungstyp und die gewünschte Leitfähigkeit einzustellen.

Nach Durchführung der erfindungsgemäßen Prozeßsequenz (a) bis (c) liegt eine epitaxierte Halbleiterscheibe mit einer schleierfreien (haze-free) Oberfläche vor, die vor ihrer weiteren Weiterverarbeitung zur Herstellung von Halbleiter-Bauelementen einer Charakterisierung ihrer Eigenschaften zugeführt werden kann. Messungen mit einem auf Laserbasis arbeitenden optischen Oberflächeninspektionsgerät zeigen eine maximale Dichte von 0,14 Streulichtzentren pro cm² epitaxierter Scheibenoberfläche und eine Oberflächenrauhigkeit (Haze) von weniger als 0,2 ppm und eine Mikrorauhigkeit von < 1nm RMS.

Eine erfindungsgemäß hergestellte epitaxierte Halbleiterscheibe, insbesondere eine Siliciumscheibe mit einer epitaktischen Siliciumbeschichtung, erfüllt die Anforderungen für die Herstellung von Halbleiterbauelementen mit Linienbreiten gleich oder kleiner 0,18 µm. Das erfindungsgemäße Verfahren hat sich als optimale Lösung zur Herstellung von epitaxierten Siliciumscheiben mit den geschilderten Merkmalen erwiesen. Es spart kostenintensive Schritte zur lokalen Geometriekorrektur wie beispielsweise Plasmaätzen. Auch eine Endpolitur ist nicht unbedingt notwendig. Durch die geringe Anzahl von Prozeßschritten ist auch das Bruchrisiko vermindert.

### Beispiel 1

Schritt (a): Für dieses Beispiel standen 300-mm-Siliciumscheiben mit doppelseitig polierter Oberfläche als Substratscheiben zur Verfügung, die entsprechend poliert, gereinigt und getrocknet worden waren. Die Rauhigkeit der vorpolierten Scheiben betrug 0,7 nm RMS (AFM, 1 µm mal 1 µm).

Schritt (b): Die Vorderseiten der Halbleiterscheiben wurden nun vor der epitaktischen Beschichtung in dem Epitaxiereaktor einer Vorbehandlung unterzogen, die zum Ziel hatte, in einem ersten Teilschritt das natürliche Oxid auf der Vorderseite zu entfernen und in einem zweiten Teilschritt die Rauhigkeit auf der Oberfläche drastisch zu verringern, so daß nach epitaktischer Beschichtung eine Halbleiterscheibe mit deutlich verbesserten Eigenschaften hinsichtlich Oberflächenrauhigkeit und Anzahl der Lichtstreuzentren zur Verfügung steht. Dies wurde dadurch erreicht, daß zunächst das natürliche Oxid in einer Wasserstoffatmosphäre bei 1120 Grad Celsius für eine Minute entfernt wurde. Danach wurde für 30 Sekunden bei einer Temperatur von 1140 Grad Celsius der Wasserstoffatmosphäre gasförmiges HCl und Trichlorsilan zugesetzt mit dem Ziel, die noch vorhandene Rauhigkeit auf der Vorderseite deutlich zu reduzieren. Abscheidereaktion und Ätzreaktion waren bei 1000 sccm HCl und 1000 sccm Trichlorsilan (Sättigungstemp. 20°C) im Gleichgewicht. Die Rauhigkeit der vorbehandelten Scheibe betrug 0,09 nm RMS.

Schritt (c): Die entsprechend dem Schritt (b) vorbehandelten Halbleiterscheiben wurden dann entsprechend dem Stand der Technik in dem Epitaxiereaktor auf der Vorderseite mit einer epitaktisch aufgewachsenen Siliciumschicht versehen, wobei als Siliciumkomponente SiHCl₃ zum Einsatz kam und der Widerstand durch Dotierung mit Diboran (B₂H₆) eingestellt wurde. Bei einer Reaktorkammertemperatur von 1140 °C wurde bei einer Abscheiderate von 3 µm/min eine Schicht der Dicke 3,2 µm abgeschieden.

### Charakterisierung der epitaxierten Siliciumscheiben:

Die mit Silicium auf der Vorderseite epitaxierten Siliciumscheiben wurden auf einem nach dem Laserprinzip arbeitenden Oberflächeninspektionsgerät des Typs SP1 der Fa. KLA-Tencor hinsichtlich ihrer Defekte auf der epitaxierten Vorderseite charakterisiert; für die Gesamtzahl der LLS-Defekte gleich oder größer 0,12 µm ergab sich im DWN-Kanal ("dark field wide") ein Mittelwert von 20 ± 9, entsprechend 0,03 LLS/ cm², der Hazewert lag bei 0,06 ± 0,03 ppm, der RMS bei 0,07 nm (1 x 1 µm²).

### Vergleichsbeispiel 1 - ohne Vorbehandlung:

Es standen Siliciumscheiben mit den gleichen Eigenschaften wie in Beispiel 1 als Substratscheiben zur Verfügung. Ohne die in der Erfindung beschriebene Vorbehandlung wurde nach der epitaktischen Beschichtung auf der Vorderseite ein Mittelwert der LLS-Defekte gleich oder größer 0,12 µm im DWN-Kanal von 368 ± 124, entsprechend 0,52 ± 0,18 LLS/cm², gefunden. Der Hazewert lag bei 0,09 ± 0,04 ppm.

### Vergleichsbeispiel 2 - Vorbehandlung nur mit HCl:

Es standen Siliciumscheiben mit den gleichen Eigenschaften wie in Beispiel 1 als Substratscheiben zur Verfügung. Die Vorderseite der Siliciumscheiben wurde vor der epitaktischen Beschichtung in dem Epitaxiereaktor einer Vorbehandlung mit HCl unterzogen. Dazu wurde für 30 Sekunden bzw. 1 Minute bei einer Temperatur von 1140 Grad Celsius einer Wasserstoffatmosphäre gasförmiges HCl zugesetzt. Die Rauhigkeit der vorbehandelten Scheiben betrug 0,32 nm RMS (30 sec) bzw. 0,17 nm RMS (1 Min), war also bei doppelter Behandlungsdauer deutlich rauher als bei der erfindungsgemäßen Vorbehandlung mit HCl und Trichlorsilan. Nach der Beschichtung mit einer epitaktischen Siliciumschicht wurde eine Gesamtzahl an LLS-Defekten von 132 ± 28 (30 sec) bzw. 22 ± 15 (1 min) gefunden; der Hazewert lag bei 0,07 t 0,03 ppm (30 sec) bzw. 0,06 ± 0,03 ppm (1 min), die RMS Rauhigkeit bei 0,10 nm (30 sec) bzw. bei 0,09 nm (1 min).

Die Vorderseiten, Rückseiten und Kanten der nach dem oben aufgeführten Beispiel und den beiden Vergleichsbeispielen hergestellten 300-mm-Siliciumscheiben wurden mit den üblichen, dem Fachmann bekannten Methoden hinsichtlich Metallkontamination der Scheibenoberfläche und Minoritätsladungsträger-Lebensdauer sowie nanotopologische Eigenschaften charakterisiert. Es wurden keine statistisch relevanten Abweichungen zwischen den einzelnen Versuchsgruppen beobachtet.

### Beispiel 2:

Schritt (a): Für dieses Beispiel standen 300-mm-Siliciumscheiben mit polierter Oberfläche als Substratscheiben zur Verfügung, bei denen eine ringförmige Anhäufung von Defektkeimen, ein sogenannter OSF-Ring, nachweisbar war.

Schritt (b): Die Vorderseiten der Halbleiterscheiben wurden vor der epitaktischen Beschichtung in dem Epitaxiereaktor einer Vorbehandlung unterzogen, die zum Ziel hatte, die Anzahl von Lichtstreuzentren, die nach der epitaktischen Beschichtung nachweisbar war, möglichst gering werden zu lassen. Dies wurde dadurch erreicht, daß zunächst das natürliche Oxid in einer Wasserstoffatmosphäre bei 1150 Grad Celsius für eine Minute entfernt wurde. Danach wurde für weitere 60 Sekunden bei einer Temperatur von 1120 Grad Celsius der Wasserstoffatmosphäre gasförmiges HCl und Trichlorsilan zugesetzt (900 sccm HCl und 2000 sccm Trichlorsilan (Sättigungstemp. 20°C)).

Schritt (c): Die entsprechend dem Schritt (b) vorbehandelten Halbleiterscheiben wurden dann entsprechend dem Stand der Technik in dem Epitaxiereaktor auf der Vorderseite mit einer epitaktisch aufgewachsenen Siliciumschicht versehen. Die Beschichtung erfolgte bei 1120 °C und dauerte 75 Sekunden.

### Charakterisierung der epitaxierten Siliciumscheiben:

Die mit Silicium auf der Vorderseite epitaxierten Siliciumscheiben wurden auf einem nach dem Laserprinzip arbeitenden Oberflächeninspektionsgerät des Typs SP1 der Fa. KLA-Tencor hinsichtlich ihrer Defekte auf der epitaxierten Vorderseite charakterisiert; die Gesamtzahl der LLS-Defekte größer 0,12 µm betrug 40.

### Vergleichsbeispiele 3-6 - mit Wärmebehandlung:

Es standen Siliciumscheiben mit den gleichen Eigenschaften wie in Beispiel 2 als Substratscheiben zur Verfügung. Vor der epitaktischen Beschichtung wurden die Siliciumscheiben statt einer erfindungsgemäßen Vorbehandlung einer 60 Sekunden dauernden Wärmebehandlung in Wasserstoff bei einer Temperatur von 1120 °C (Vergleichsbeispiel 3), 1150 °C (Vergleichsbeispiel 4) und 1200 °C (Vergleichsbeispiel 5) unterzogen. Im Vergleichsbeispiel 6 lag die Behandlungstemperatur ebenfalls bei 1150 °C, die Behandlungsdauer betrug jedoch 120 Sekunden. Die Bedingungen der sich an die Wärmebehandlung anschließenden epitaktischen Beschichtung waren im Fall der Vergleichsbeispiele 4 bis 6 identisch mit denen von Beispiel 2. Im Fall von Vergleichsbeispiel 3 erfolgte die Beschichtung bei 1090 °C und dauerte 81 Sekunden. Die Zahl der nach der epitaktischen Beschichtung gezählten LLS-Defekte betrug 2577 (Vergleichsbeispiel 3), 428 (Vergleichsbeispiel 4), 239 (Vergleichsbeispiel 5), beziehungsweise 509 (Vergleichsbeispiel 6).

### Vergleichsbeispiel 7 - Vorbehandlung nur mit HCL:

Es standen Siliciumscheiben mit den gleichen Eigenschaften wie in Beispiel 2 als Substratscheiben zur Verfügung. Im Unterschied zu Beispiel 2 wurde auf die Zugabe von Trichlorsilan verzichtet. Die folgende epitaktische Beschichtung wurde unter denselben Bedingungen wie in Beispiel 2 durchgeführt. Die Zahl der detektierten LLS-Defekte betrug 110.

## Patentansprüche

1. Verfahren zur Herstellung einer Halbleiterscheibe mit einer Vorderseite und einer Rückseite und einer auf der Vorderseite abgeschiedenen epitaktischen Schicht aus halbleitendem Material, **dadurch gekennzeichnet, daß** das Verfahren folgende Prozeßschritte umfaßt:
(a) Bereitstellen einer Substratscheibe aus Silicium mit einer polierten Vorderseite und einer bestimmten Dicke;
(b) Vorbehandeln der Vorderseite der Substratscheibe in Gegenwart von gasförmigem HCl und einer Silanquelle bei einer Temperatur von 950 bis 1250 Grad Celsius in einem Epitaxiereaktor, wobei die Dicke der Substratscheibe im wesentlichen unverändert bleibt; und
(c) Abscheiden der epitaktischen Schicht auf der Vorderseite der vorbehandelten Substratscheibe.

2. Verfahren nach Anspruch 1, **dadurch gekennzeichnet, daß** die polierte Vorderseite gemäß Schritt (a) mit einer Abtragspolitur als einzigem Polierschritt erzeugt wird.

3. Verfahren nach Anspruch 1 oder Anspruch 2, **dadurch gekennzeichnet, daß** die Substratscheibe Defekte aufweist, die als oberflächennahe Oxidpräzipitate oder als mit Oxid angefüllten Leerstellenagglomerate (voids) nachweisbar sind.

4. Verfahren nach Anspruch 3, dadurch gegennzeichnet, daß die Substratscheibe Sauerstoff in einem Konzentrationsbereich von 3*10¹⁷ - 9*10¹⁷ cm⁻³ und mindestens einen Dotierstoff enthält, der aus einer Gruppe ausgewählt ist, die Stickstoff, Kohlenstoff und Bor umfasst, und die Konzentration des Dotierstoffs in Abhängigkeit des Dotierstoff-Typs in einen der folgenden Konzentrationsbereiche fällt:
Konzentrationsbereich von Stickstoff: 1*10¹⁰ - 5*10¹⁵ cm⁻³;
Konzentrationsbereich von Kohlenstoff: 1*10¹⁵ - 5*10¹⁷ cm⁻³;
Konzentrationsbereich von Bor: mehr als 5*10¹⁷ cm⁻³.

5. Verfahren nach einem der Ansprüche 1 bis 4, **dadurch gekennzeichnet, daß** zum Erzeugen der polierten Vorderseite die Vorder- und die Rückseite der Substratscheibe gleichzeitig poliert werden.

6. Verfahren nach einem der Ansprüche 1 bis 4, **dadurch gekennzeichnet, daß** zum Erzeugen der polierten Vorderseite nur die Vorderseite der Substratscheibe poliert wird.

7. Verfahren nach einem der Ansprüche 1 bis 6, **dadurch gekennzeichnet, daß** das Vorbehandeln der Substratscheibe und das Abscheiden der epitaktischen Schicht unmittelbar nacheinander im Epitaxiereaktor durchgeführt werden.

8. Verfahren nach einem der Ansprüche 1 bis 7, **dadurch gekennzeichnet, daß** beim Vorbehandeln der Substratscheibe gemäß Schritt (b) die Substratscheibe in einem ersten Teilschritt von nativem Oxid befreit wird und in einem zweiten Teilschritt bei einer Temperatur von 950 bis 1250 Grad Celsius in einer Wasserstoffatmosphäre behandelt wird, der gasförmiges HCl und eine Silanquelle beigemischt sind.

9. Verfahren nach einem der Ansprüche 1 bis 8, **dadurch gekennzeichnet, daß** die Silanquelle aus einer Gruppe von Verbindungen ausgewählt wird, die Silan (SiH₄), Dichlorsilan (SiH₂Cl₂), Trichlorsilan (SiHCl₃), Tetrachlorsilan (SiCl₄) und beliebige Mischungen der genannten Stoffe umfaßt.

10. Verfahren nach einem der Ansprüche 1 bis 9, **dadurch gekennzeichnet, daß** das Verhältnis von HCl- und Silankonzentration zu einer Siliciumabscheidung mit einer Abscheiderate von weniger als 0.5 µm/min oder zu einer Siliciumätze mit einer Ätzrate von weniger als 0.2 µm/min führt und weniger als 0,5 µm an Material von der Oberfläche der Substratscheibe abgetragen und weniger als 0,5 µm an Material auf der Oberfläche der Substratscheibe abgeschieden wird.

11. Verfahren nach einem der Ansprüche 1 bis 10, **dadurch gekennzeichnet, daß** die in Schritt (c) abgeschiedene epitaktische Schicht eine Dicke von 0,3 µm bis 10 µm besitzt und bei einer Temperatur von 600 °C bis 1250 °C abgeschieden wird.

12. Verfahren nach einem der Ansprüche 1 bis 11, **dadurch gekennzeichnet, daß** die in Schritt (c) abgeschiedene epitaktische Schicht mit einem oxidierenden Gas hydrophiliert wird.

13. Verfahren nach einem der Ansprüche 1 bis 11, **dadurch gekennzeichnet, daß** die in Schritt (c) abgeschiedene epitaktische Schicht naßchemisch hydrophiliert wird.

14. Verwendung einer nach einem der Ansprüche 1 bis 13 hergestellten epitaxierten Halbleiterscheibe zur Herstellung von integrierten Halbleiter-Bauelementen.

## Claims

1. Method for the production of a semiconductor wafer having a front and a back and an epitaxial layer of semiconductor material deposited on the front, **characterized in that** the method comprises the following process steps:
(a) preparing a substrate wafer made of silicon and having a polished front and a specific thickness;
(b) pretreating the front of the substrate wafer in the presence of HCl gas and a silane source at a temperature of from 950 to 1250 degrees Celsius in an epitaxy reactor, the thickness of the substrate wafer remaining substantially unchanged; and
(c) depositing the epitaxial layer on the front of the pretreated substrate wafer.

2. Method according to Claim 1, **characterized in that** the polished front according to step (a) is created using an abrasive polish as the only polishing step.

3. Method according to Claim 1 or Claim 2,
**characterized in that** the substrate wafer has defects which are detectable as near-surface oxide precipitates or as oxide-filled voids.

4. Method according to Claim 3, **characterized in that** the substrate wafer contains oxygen in a concentration range of from 3*10¹⁷ to 9*10¹⁷ cm⁻³ and at least one dopant which is selected from a group that comprises nitrogen, carbon and boron, and the concentration of the dopant lies in one of the following concentration ranges, depending on the dopant type:
nitrogen concentration range: 1*10¹⁰ to 5*10¹⁵ cm⁻³
carbon concentration range: 1*10¹⁵ to 5*10¹⁷ cm⁻³
boron concentration range: less than 5*10¹⁷ cm⁻³.

5. Method according to one of Claims 1 to 4, **characterized in that** the front and back of the substrate wafer are simultaneously polished to create the polished front.

6. Method according to one of Claims 1 to 4, **characterized in that** only the front of the substrate wafer is polished to create the polished front.

7. Method according to one of Claims 1 to 6, **characterized in that** the pretreatment of the substrate wafer and the deposition of the epitaxial layer are carried out immediately after one another in the epitaxy reactor.

8. Method according to one of Claims 1 to 7, **characterized in that** during the pretreatment of the substrate wafer according to step (b), native oxide is removed from the substrate wafer in a first sub-step and, in a second sub-step, the substrate wafer is treated at a temperature of from 950 to 1250 degrees Celsius in a hydrogen atmosphere to which HCl gas and a silane source are added.

9. Method according to one of Claims 1 to 8, **characterized in that** the silane source is selected from a group of compounds that comprises silane (SiH₄), dichlorosilane (SiH₂Cl₂), trichlorosilane (SiHCl₃), tetrachlorosilane (SiCl₄) and any mixtures of said substances.

10. Method according to one of Claims 1 to 9, **characterized in that** the ratio of the HCl and silane concentrations leads to deposition of silicon with a deposition rate of less than 0.5 µm/min or to etching of silicon with an etching rate of less than 0.2 um/min, and less than 0.5 µm of material is eroded from the surface of the substrate wafer and less than 0.5 µm of material is deposited on the surface of the substrate wafer.

11. Method according to one of Claims 1 to 10, **characterized in that** the epitaxial layer deposited in step (c) has a thickness of from 0.3 µm to 10 µm, and is deposited at a temperature of from 600°C to 1250°C.

12. Method according to one of Claims 1 to 11, **characterized in that** the epitaxial layer deposited in step (c) is hydrophilicized using an oxidizing gas.

13. Method according to one of Claims 1 to 11, **characterized in that** the epitaxial layer deposited in step (c) is wet-chemically hydrophilicized.

14. Use of an epitaxially grown semiconductor wafer produced according to one of Claims 1 to 13 to produce integrated semiconductor components.

## Revendications

1. Procédé de fabrication d'un disque semi-conducteur ayant une face recto et une face verso et une couche épitactique déposée sur la face recto en matériau semi-conducteur, **caractérisé en ce que** le procédé comprend les étapes de procédé suivantes:
(a) la mise à disposition d'un disque substrat en silicium ayant une face recto polie et une épaisseur déterminée ;
(b) le traitement préalable de la face recto du disque substrat en présence d'HCl gazeux et d'une source de silane à une température de 950 à 1250 degrés Celsius dans un réacteur à épitaxie, l'épaisseur du disque substrat restant pour l'essentiel inchangé ;
(c) le dépôt de la couche épitactique sur la face recto du disque substrat après traitement préalable.

2. Procédé selon la revendication 1, **caractérisé en ce que** la face recto polie conformément à l'étape de procédé (a) est produite par un polissage à enlèvement en tant qu'étape unique de polissage.

3. Procédé selon la revendication 1 ou la revendication 2, **caractérisé en ce que** le disque substrat présente des défauts, qui sont détectables en tant que précipités d'oxydes proches de la surface ou en tant qu'agglomérats d'espaces vides (voids) remplis d'oxyde.

4. Procédé selon la revendication 3, **caractérisé en ce que** le disque substrat contient de l'oxygène dans un domaine de concentration de 3*10¹⁷ - 9*10¹⁷ cm⁻³ et au moins une substance de dopage, qui est sélectionnée parmi un groupe qui comprend l'azote, le carbone et le bore, et **en ce que** la concentration de la substance de dopage tombe dans l'un des domaines de concentration suivants, en fonction du type de la substance de dopage :
Domaine de concentration de l'azote : 1*10¹⁰ 5*10¹⁵ cm⁻³
Domaine de concentration du carbone : 1*10¹⁵ 5*10¹⁷ cm⁻³
Domaine de concentration du bore : plus de 5*10¹⁷ cm⁻³.

5. Procédé selon l'une quelconque des revendications 1 à 4, **caractérisé en ce qu'**en vue de la production de la face recto polie, la face verso et la face recto du disque substrat sont polies simultanément.

6. Procédé selon l'une quelconque des revendications 1 à 4, **caractérisé en ce qu'**en vue de la production de la face recto polie, seule la face recto du disque substrat est polie.

7. Procédé selon l'une quelconque des revendications 1 à 6, **caractérisé en ce que** le traitement préalable du disque substrat et le dépôt de la couche épitactique sont effectués immédiatement l'un après l'autre dans le réacteur à épitaxie.

8. Procédé selon l'une quelconque des revendications 1 à 7, **caractérisé en ce que**, lors du traitement préalable du disque substrat conformément à l'étape (b), le disque substrat est débarrassé, dans une première étape partielle, de l'oxyde natif et est traité, dans une deuxième étape partielle, à une température de 950 à 1250 degrés Celsius dans une atmosphère d'hydrogène, auquel sont ajoutés de l'HCl gazeux et une source de silane.

9. Procédé selon l'une quelconque des revendications 1 à 8, **caractérisé en ce que** la source de silane est sélectionnée parmi un groupe de composés, qui comprend le silane (SiH₄), le dichlorosilane (SiH₂Cl₂), le trichlorosilane (SiHCl₃), le tétrachlorosilane (SiCl₄) et des mélanges quelconques des substances citées.

10. Procédé selon l'une quelconque des revendications 1 à 9, **caractérisé en ce que** le rapport de la concentration de HCl et de silane conduit à un dépôt de silicium ayant une vitesse de dépôt de moins de 0,5 µm/minute ou à un mordançage de silicium ayant une vitesse de mordançage de moins de 0,2 µm/minute et **en ce que** moins de 0,5 µm de matériau est éliminé de la surface du disque substrat.

11. Procédé selon l'une quelconque des revendications 1 à 10, **caractérisé en ce que** la couche épitactique déposée dans l'étape (c) possède une épaisseur de 0,3 µm à 10 µm et est déposée à une température de 600°C à 1250°C.

12. Procédé selon l'une quelconque des revendications 1 à 11, **caractérisé en ce que** la couche épitactique déposée dans l'étape (c) est soumise à un traitement d'imperméabilisation à l'aide d'un gaz oxydant.

13. Procédé selon l'une quelconque des revendications 1 à 11, **caractérisé en ce que** la couche épitactique déposée dans l'étape (c) est soumise à un traitement d'imperméabilisation par voie chimique humide.

14. Utilisation d'un disque semi-conducteur épitactique, fabriqué selon l'une quelconque des revendications 1 à 13, en vue de la fabrication d'éléments semi-conducteurs intégrés.
